# FASCICULE DE BREVET EUROPEEN

(11) **EP 0 421 939 B1**
(45) Date de publication et mention de la délivrance du brevet: **12.04.1995**
(21) Numéro de dépôt: 90810757.6
(22) Date de dépôt: 04.10.1990
(51) Int. Cl.: H04L 25/26, H01R 13/66, G08C 23/00

(54) **Dispositif de liaison et de connexion pour instruments de mesure**
Verbindungs- und Anschlussvorrichtung für Messinstrumente
Linking and connection device for measuring instruments

(30) Priorité: 06.10.1989 CH 3668/89
(43) Date de publication de la demande: 10.04.1991
(73) Titulaire: Meyer, Hans Ulrich, CH-1110 Morges (CH)
(72) Inventeur: Meyer, Hans Ulrich, CH-1110 Morges (CH)
(74) Mandataire: Steen, Dieter Markus

(56) Documents cités:
- EP-A- 0 233 638
- WO-A-88/08184
- DE-A- 3 013 705
- US-A- 3 867 567
- IBM TECHNICAL DISCLOSURE BULLETIN. vol. 30, no. 6, novembre 1987, NEW YORK US pages 151 - 152; "pinned optical connector system"

## Description

La présente invention concerne un dispositif de liaison et de connexion destiné à relier un instrument de mesure à une unité d'acquisition de données et comprenant un connecteur avec un organe de couplage optique pour transmettre des données de l'instrument de mesure vers l'unité d'acquisition de données.

Les exigences à respecter concernant un tel dispositif reliant par exemple un pied à coulisse ou un micromètre à une unité d'acquisition de données, tel qu'un ordinateur, une imprimante, un modem ou un dispositif d'affichage, sont multiples :
- très faible consommation de courant additionnelle sur l'instrument de mesure, vu que celui-ci n'est généralement équipé que de batteries à faible capacité.
- faible consommation de courant sur l'unité d'acquisition, leurs connecteurs ne pouvant généralement fournir que quelques milliampères.
- simplicité de connexion et d'utilisation : en particulier la fonction de mesure de l'instrument ne doit pas être gênée par la liaison.
- fiabilité et immunité suffisantes aux perturbations électriques : en particulier, les parties métalliques exposées de l'instrument de mesure ne devraient pas être reliées galvaniquement à l'unité d'acquisition pour éviter des boucles de courant perturbant le bon fonctionnement de l'instrument ou de la liaison.
- coût très faible, en particulier en ce qui concerne les éléments de liaison montés sur l'instrument et grevant donc le prix de celui-ci, même s'il n'est jamais relié.
- compatibilité avec les connecteurs sériels (par exemple du type RS 232) existants sur les unités d'acquisition.

La liaison sérielle la plus répandue actuellement entre une unité d'acquisition et un périphérique est celle définie par la norme EIA RS 232. Mais cette liaison ne peut être utilisée sans modifications pour des instruments de mesure du type pied à coulisse ou micromètre, qui devraient dans ce cas fournir des courants trop élevés.

Pour éviter ceci, certains périphériques, tels que les "souris" ou capteurs de déplacement à deux dimensions, sont alimentés par l'ordinateur au travers de certaines lignes du connecteur.

Cette solution ne peut être retenue pour un pied à coulisse ou un micromètre, car le couplage galvanique pourrait perturber le bon fonctionnement de l'électronique de l'instrument de mesure.

Une liaison par fibres optiques est aussi faisable, mais présente les inconvénients d'une trop grande rigidité de la fibre gainée, gênant ainsi la manipulation de l'instrument de mesure, de problèmes de connexion et d'un prix de revient élevé.

On connaît ainsi du document WO 88/08184 un instrument de mesure qui transmet les données de mesure par transmission radio vers une unité d'acquisition de données.

Cette transmission radio est d'une part sujette à des perturbations possibles et d'autre part d'un prix de revient élevé.

Le document IBM Technical Disclosure Bulletin Vol. 30, No 6, 1987, pages 151, 152 décrit une prise de contact reliant un ordinateur personnel à un équipement périphérique.

Cette prise comprend, d'une part, des fiches de contact galvanique pour transmettre l'énergie électrique à l'équipement périphérique et, d'autre part, un couplage optique destiné à la transmission des données. Le couplage optique est utilisé dans le but d'éviter une usure prématurée des fiches.

Le dispositif selon la présente invention est destiné à éviter les inconvénients des instruments précités et à obtenir une liaison d'un instrument de mesure à une unité d'acquisition de données absolument non galvanique, d'une construction simple et fiable et dans laquelle le courant demandé par la transmission est minimisé. Le dispositif de liaison est caractérisé à cet effet par le fait que le connecteur comprend un connecteur muni d'un photodétecteur susceptible d'envoyer par câble des signaux électriques à l'unité, le connecteur étant agencé de façon à coopérer avec une portion conforme de l'instrument de mesure munie d'un photoémetteur susceptible de recevoir de signaux électriques d'un circuit électrique de l'instrument de mesure et d'émettre des signaux photoniques vers le photodétecteur, ce circuit amplificateur associé au photodétecteur, ce circuit amplificateur comprenant deux lignes d'alimentation reliées à ladite unité entre lesquelles sont branchés en parallèle, d'une part, une résistance suivie du photodétecteur et, d'autre part, un transistor dont le collecteur est relié à une diode régulatrice de courant, la base du transistor étant connectée à l'entrée du photodétecteur, le collecteur de ce transistor fournissant le signal amplifié par câble vers ladite unité.

Ces mesures ont pour avantages :
- de séparer galvaniquement l'instrument de l'unité d'acquisition;
- de permettre l'utilisation d'un câble électrique, plus souple qu'un câble optique et qui peut être directement connecté à la plupart des unités d'acquisition actuelles;
- d'éviter un coût et un encombrement supplémentaires élevés, en particulier sur l'instrument où il n'est nécessaire d'ajouter que deux composants, une diode lumineuse et un phototransistor, de taille et de prix réduits et dont le coût additionnel est compensé par l'élimination du connecteur électrique monté sur l'instrument.
- de minimiser le courant demandé par la transmission de données.

Selon une variante avantageuse interactive, le connecteur est muni d'un photoémetteur susceptible d'émettre des signaux photoniques vers un photodétecteur disposé sur ladite portion, le photoémetteur étant relié par câble à ladite unité et le photodétecteur étant susceptible d'envoyer des signaux électriques audit circuit électrique de l'instrument de mesure.

Selon un mode d'exécution préféré de l'invention, le connecteur comprend un corps de forme générale plate présentant un évidement central dans lequel est fixé un circuit imprimé portant une diode luminescente en tant que photoémetteur, un phototransistor, en tant que photodétecteur, et ledit circuit amplificateur, le corps étant susceptible d'être inséré dans une cavité de forme correspondante prévue sur l'instrument de mesure de façon que sa diode luminescente se trouve en regard d'un phototransistor de l'instrument de mesure et que son phototransistor soit situé en regard d'une diode luminescente de l'instrument de mesure.

D'autres avantages ressortent des caractéristiques des revendications dépendantes et de la description d'un mode d'exécution de l'invention exposé ci-après schématiquement et à titre d'exemple, à l'aide de dessins.

La figure 1 montre un pied à coulisse en coupe partielle muni d'un dispositif conforme à l'objet de l'invention.

La figure 2 représente un connecteur utilisé dans le dispositif conforme à l'objet de l'invention.

La figure 3 illustre le dispositif en coupe transversale.

La figure 4 montre le schéma électrique associé et la figure 5 les formes d'ondes s'y rapportant.

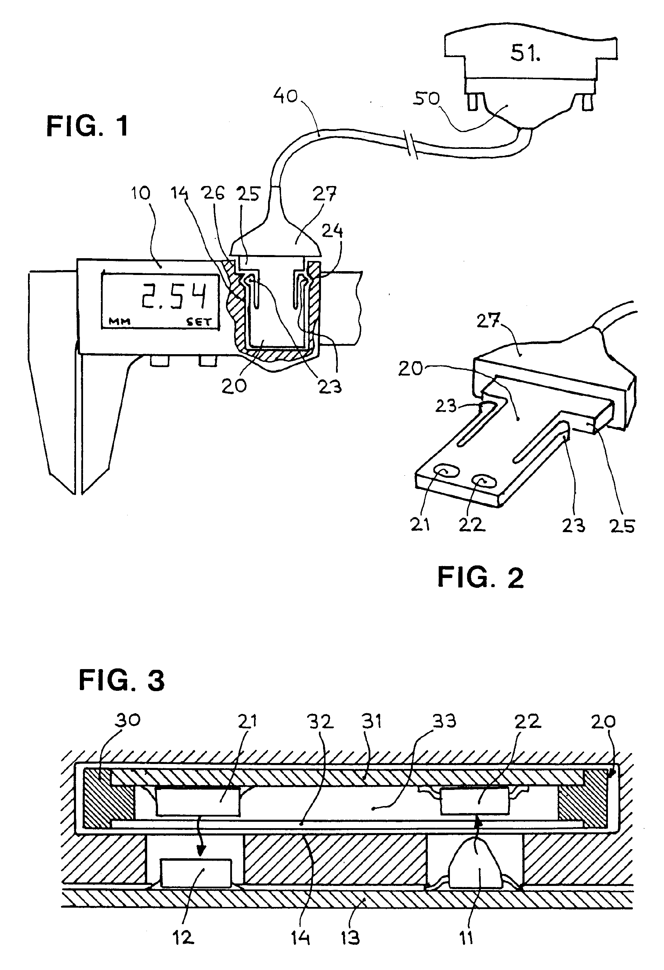

En référence aux figures 1, 2 et 3, l'instrument 10, ici un pied à coulisse digital, présente une cavité 14, dans laquelle le connecteur 20 est inséré. Le positionnement de ce connecteur 20 est assuré par la forme de la cavité 14, épousant celle du connecteur 20. Dans le sens de l'insertion, la position du connecteur 20 est fixée par la présence de deux tétons 23 venus d'une pièce avec le corps 30 du connecteur 20. Ces tétons 23 se logent dans deux évidements 24 prévus dans l'instrument de mesure 10 et présentent une certaine élasticité contrôlant ainsi les forces d'insertion et d'extraction du connecteur 20.

Un détrompeur 25 sur le connecteur 20, ainsi qu'un évidement correspondant 26 sur l'instrument de mesure garantissent l'orientation correcte du connecteur 20, de manière à ce qu'une diode luminescente 21 et qu'un phototransistor 22 disposés sur le connecteur se trouvent bien en regard d'un phototransistor 12 et d'une diode luminescente 11 de l'instrument de mesure (voir la coupe de la figure 3).

Le connecteur 20 se prolonge par un manchon 27 et un câble 40 reliant le connecteur 20 au connecteur 50 branché sur un port sériel d'un système d'acquisition 51.

La figure 3 montre en coupe le connecteur 20 dans sa cavité 14, où il est disposé en face de la diode luminescente 11 et du phototransistor 12 montés sur un circuit imprimé 13 du pied à coulisse 10.

Les flèches indiquent le sens du transfert optique d'informations : de la diode luminescente 21 au phototransistor 12, c'est-à-dire, du connecteur 20 au pied à coulisse 10, et de la diode luminescente 11 au phototransistor 22, c'est-à-dire du pied à coulisse 10 au connecteur 20. Le connecteur 20 est réalisé de manière à avoir un faible encombrement surtout en épaisseur. Le corps 30 du connecteur 20 comporte un évidement 33. Sur ce corps sont fixés d'un côté un circuit imprimé à une couche 31, sur lequel sont soudés la diode luminescente 21, le phototransistor 22, et les autres composants nécessaires pour l'obtention des signaux désirés placés dans le reste de l'évidement 33. Un couvercle 32 transparent, du moins en regard des composants optoélectriques, ferme le connecteur du côté opposé au circuit imprimé.

Les composants sont de préférence du type CMS (composants montés en surface) afin de réduire l'encombrement.

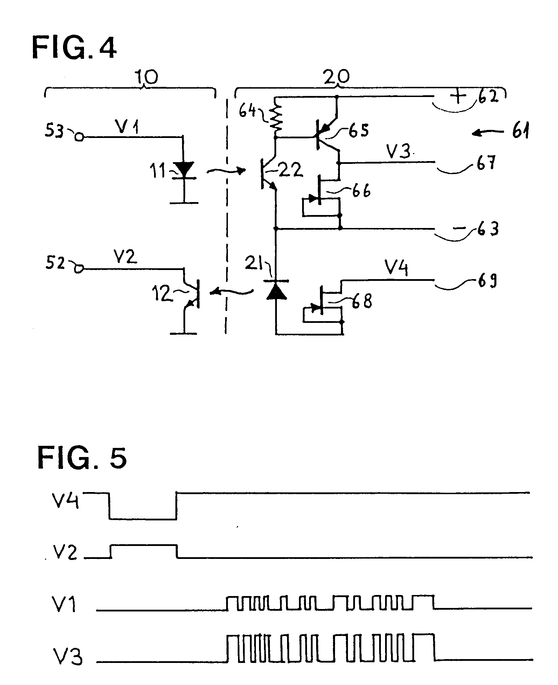

Le circuit électronique montré à la figure 4 est constitué de telle manière que la diode luminescente 11, servant de photoémetteur de l'instrument, soit inactive, donc que le signal V1 généré à la sortie 53 d'un microcontrôleur de l'instrument de mesure 10 soit nul, lorsqu'il n'y a pas de transmission de résultats.

Du côté du connecteur 20, le phototransistor 22, servant de photodétecteur, est associé à un circuit amplificateur 61 comprenant deux lignes d'alimentation 62, 63 entre lesquelles sont branchés en parallèle, d'une part une résistance 64 (50 KOhm) suivie du phototransistor 22 et, d'autre part, un transistor 65 du type PNP, dont le collecteur est relié à une diode régulatrice de courant 66 assurant un courant constant (1,5 mA) à partir d'une certaine différence de potentiel (2 volt). Cette diode 66 pourait être remplacée par une résistance (3 à 5 KOhm). La base du transistor PNP 65 est connectée à l'entrée du phototransistor 22 et le collecteur de ce transistor PNP 65 fournit par la ligne de transmission 67 le signal amplifié V3 vers l'unité d'acquisition 51.

En conséquence, lorsque la diode luminescente 11 est inactive et le signal V1 à la borne 53 est nul, aucun courant ne passe par le phototransistor 22. De ce fait, la base du transistor PNP 65 est maintenue au potentiel de la ligne 62 reliée à l'émetteur du transistor PNP 65, donc aucun courant ne passe par le transistor PNP 65. La diode régulatrice de courant 66 maintient la ligne de transmission 67 au potentiel négatif. Lorsque des données sont transmises et que le signal V1 cesse d'être nul, la diode luminescente 11 émet de la lumière et rend le phototransistor 22 assez conducteur pour tirer du courant par la base du transistor 65. Celui-ci devient alors conducteur a son tour et le signal V3 sur la ligne 67 devient positif, tel que cela est illustré à la figure 5.

Par cette disposition, le courant demandé à l'instrument de mesure 10 est minimisé pour la transmission des résultats de mesure à l'unité d'acquisition 51 de l'ordinateur.

En ce qui concerne la transmission des signaux de l'unité d'acquisition 51 vers l'instrument de mesure 10, la diode luminescente 21 du connecteur est reliée par l'intermédiaire d'une deuxième diode régulatrice de courant 68 a la ligne 69 par laquelle elle reçoit les signaux de commande V4 de l'unité d'acquisition 51, l'autre borne de la diode luminescente 21 étant reliée à la ligne 63. La lumière émise par la diode luminescente 21 est captée par le phototransistor 12 de l'instrument de mesure 10 qui transmet un signal électrique V2 à l'entrée 52 du microcontrôleur. Dans le circuit décrit, la ligne 69 est mise à une tension positive et la diode luminescente 21 émet un signal photonique d'une longueur d'onde visible ou infrarouge, qui est capté et transmis au microcontrôleur. Ce dernier peut être programmé de façon à reconnaître la présence du connecteur 20 par la présence du signal photonique. Lorsque l'unité de commande 51 demande un résultat de mesure en mettant la ligne 69 à un potentiel négatif, le courant dans la diode régulatrice 68 et dans la diode luminescente 21 est arrêté. Le phototransistor 12 cesse alors d'être conducteur et le changement de la tension du signal V2 peut être lu par l'entrée 52 du microcontrôleur qui commande la transmission d'un résultat de mesure comme décrit ci-dessus.

Il est clair que le résultat de mesure peut aussi être transmis de manière asynchrone par l'instrument de mesure. Pour des instruments de mesure plus sophistiqués, la ligne 69 peut également transmettre des données plus spécifiques de l'unité d'acquisition 51 à l'instrument de mesure 10, par exemple des valeurs de préréglage ou des limites de tolérance, etc.

En choisissant des composants opto-électriques de bonne qualité et de technologie récente, on arrive facilement avec des courants inférieurs à 1 mA dans la diode luminescente 11, à des vitesses de transmission de 4800 bits/seconde sur des lignes de plus de 15 m. Si l'on suppose que les messages transmis sont courts, pour le pied à coulisse environ 10 caractères ASCII par résultat, on peut calculer que si l'on transmet un résultat par seconde, ce qui est beaucoup pour un tel instrument, la consommation moyenne de courant de l'instrument n'augmentera que de 0.01 mA. En branchant correctement les signaux, les lignes transmettant les signaux V3 et V4, ainsi que les alimentations positives 62 et négatives 63 au port sériel d'une unité d'acquisition, il n'y a besoin d'aucun circuit supplémentaire pour assurer la liaison entre l'instrument de mesure et l'unité d'acquisition.

Les circuits électroniques associés au microcontrôleur et à l'instrument de mesure 10 ne faisant pas l'objet de la présente invention, ils ne sont donc pas décrit ici; des exemples d'exécution sont exposés dans les brevets americains N° 4.437.055 et N° 4.841.225.

Il est bien entendu que le mode l'exécution du dispositif de liaison et de connexion décrit ci-dessus ne présente aucun caractère limitatif et qu'il peut recevoir toutes modifications désirables à l'intérieur du cadre défini par la revendication indépendante. Ainsi, il n'est pas nécessaire de disposer les diodes luminescentes et les phototransistors respectifs en regard les uns par rapport aux autres. Pour réduire davantage l'encombrement du connecteur 20, il pourrait être nécessaire de les disposer dans un seul plan et de transmettre la lumière de l'une à l'autre par des réflecteurs ou guides de lumière agencés de façon adéquate. Au lieu d'un dispositif de liaison fonctionnant dans les deux sens, on pourra, selon une variante simplifiée, uniquement utiliser une liaison ne comportant qu'un photoémetteur du côté de l'instrument et un photodétecteur disposé sur le connecteur. Au lieu d'être d'une forme générale rectangulaire, ce dernier pourra présenter une toute autre géométrie.

## Revendications

1. Dispositif de liaison et de connexion destiné à relier un instrument de mesure (10) à une unité d'acquisition de données (51) et comprenant un connecteur avec un organe de couplage optique pour transmettre des données de l'instrument de mesure (10) vers l'unité d'acquisition de données (5), caractérisé en ce que le connecteur (20) est muni d'un photodétecteur (22) susceptible d'envoyer par câble (40) des signaux électriques (V3) à l'unité (51), le connecteur (20) étant agencé de façon à coopérer avec une portion conforme (14) de l'instrument de mesure (10) munie d'un photoémetteur (11) susceptible de recevoir des signaux électriques (V1) d'un circuit électrique de l'instrument de mesure (10) et d'émettre des signaux photoniques vers le photodétecteur (22), le connecteur (20) comprenant un circuit amplificateur (61) associé au photodétecteur (22), ce circuit amplificateur (61) comprenant deux lignes d'alimentation (62,63) reliées à ladite unité (51) entre lesquelles sont branchés en parallèle, d'une part, une résistance (64) suivie du photodétecteur (22) et, d'autre part, un transistor (65) dont le collecteur est relié à une diode régulatrice de courant (66), la base du transistor étant connectée à l'entrée du photodétecteur (22), le collecteur de ce transistor (65) fournissant le signal amplifié (V3) par câble (40) vers ladite unité (51).

2. Dispositif selon la revendication 1, caractérisé en ce que le connecteur (20) est muni d'un photoémetteur (21) susceptible d'émettre des signaux photoniques vers un photodétecteur (12) disposé sur ladite portion (14), le photoémetteur (21) étant relié par câble (40) à ladite unité (51) et le photodétecteur (12) étant susceptible d'envoyer des signaux électriques (V2) audit circuit électrique de l'instrument de mesure (10).

3. Dispositif selon la revendication 2, caractérisé en ce que le photoémetteur (21) disposé sur le connecteur (20) est relié par l'intermédiaire d'une diode régulatrice de courant (68) à ladite unité (51).

4. Dispositif selon la revendication 3, caractérisé en ce que le connecteur (20) comprend un corps (30) de forme générale plate présentant un évidement central (33) dans lequel est fixé un circuit imprimé (31) portant une diode luminescente (21) en tant que photoémetteur, un phototransistor (22), en tant que photodétecteur, et ledit circuit amplificateur (61), le corps (30) étant susceptible d'être inséré dans une cavité (14) de forme correspondante prévue sur l'instrument de mesure (10) de façon que sa diode luminescente (21) se trouve en regard d'un phototransistor (12) de l'instrument de mesure (10) et que son phototransistor (22) soit situé en regard d'une diode luminescente (11) de l'instrument de mesure (10).

5. Dispositif selon la revendication 4, caractérisé en ce que le corps du connecteur (30) est venu d'une pièce avec deux tétons latéraux (23) élastiques destinés à se loger dans deux évidements (24) prévus dans ladite cavité (14) de façon à maintenir élastiquement le connecteur (20) dans la cavité (14).

## Patentansprüche

1. Verbindungs- und Anschlussvorrichtung, die dazu bestimmt ist, ein Messgerät (10) mit einer Datenerfassungseinheit (51) zu verbinden, und einen Stecker mit einem optischen Kopplungsorgan umfasst, um Daten vom Messgerät (10) zur Datenerfassungseinheit (51) zu übertragen, dadurch gekennzeichnet, dass der Stecker (20) mit einem Photodetektor (22) ausgerüstet ist, der imstande ist, durch das Kabel (40) elektrische Signale (V3) zur Einheit (51) zu senden, wobei der Stecker (20) dafür eingerichtet ist, mit einer entsprechenden Partie (14) des Messgeräts (10) zusammenzuwirken, die ihrerseits mit einem Photoemitter (11) ausgerüstet ist, der imstande ist, elektrische Signale (V1) von einem elektrischen Schaltkreis des Messgeräts (10) aufzunehmen und Lichtquantensignale in Richtung auf den Photodetektor (22) auszusenden, und der Stecker (20) eine dem Photodetektor (22) zugeordnete Verstärkerschalltung (61) mit zwei Stromzuführungen (62, 63) enthält, die mit der benannten Einheit (51) verbunden sind und zum einen über einen Widerstand (64) in Reihe mit dem Photodetektor (22) und zum anderen dazu parallel über einen Transistor (65) miteinander verbunden sind, wobei der Kollektor des Transistors an eine Stromreglerdiode (66) und die Basis des Transistors an den Eingang des Photodetektors (22) angeschlossen ist und der Kollektor dieses Transistors (65) das verstärkte Signal (V3) durch Kabel (40) an die benannte Einheit (51) liefert.

2. Vorrichtung gemäss Anspruch 1, dadurch gekennzeichnet, dass der Stecker (20) mit einem Photoemitter (21) ausgerüstet ist, der imstande ist, Lichtquantensignale in Richtung auf einen auf der benannten Partie (14) angeordneten Photodetektor (12) auszusenden, und durch Kabel (40) mit der benannten Einheit (51) verbunden ist, wobei der Photodetektor (12) imstande ist, elektrische Signale (V2) zu der benannten elektrischen Schaltung des Messgeräts (10) zu senden.

3. Vorrichtung gemäss Anspruch 2, dadurch gekennzeichnet, dass der auf dem Stecker (20) angeordnete Photoemitter (21) über eine Stromreglerdiode (68) mit der benannten Einheit (51) verbunden ist.

4. Vorrichtung gemäss Anspruch 3, dadurch gekennzeichnet, dass der Stecker (20) einen allgemein flach geformten Kern (30) enthält, der in der Mitte eine Aussparung (33) hat, in der eine gedruckte Schaltung (31) untergebracht ist, auf der sich eine als Photoemitter dienende Leuchtdiode (21) und ein als Photodetektor dienender Phototransistor (22) sowie die benannte Verstärkerschaltung (61) befinden, wobei der Kern (30) in eine Vertiefung (14) entsprechender Form eingeführt werden kann, die so am Messgerät (10) angeordnet ist, dass seine Leuchtdiode (21) einem Phototransistor (12) des Messgeräts (10) gegenüberliegt und dass sein Phototransistor (22) einer Leuchtdiode (11) des Messgeräts (10) gegenüberliegt.

5. Vorrichtung gemäss Anspruch 4, dadurch gekennzeichnet, dass der Kern des Steckers (30) eine Einheit bildet mit zwei seitlichen elastischen Fingern (23), die dazu bestimmt sind, in zwei Aussparungen (24) einzurasten, die in der benannten Vertiefung (14) angeordnet sind, um dadurch den Stecker (20) elastisch in der Vertiefung (14) festzuhalten.

## Claims

1. A linking and connecting device designed for connecting a measuring instrument (10) to a data acquisition unit (51) and including a connector with an optical coupling member for transmitting data from the optical measuring instrument (10) to the data acquisition unit (5), characterized in that the connector (20) is provided with a photodetector (22) capable of sending via a cable (40) electric signals (V3) to the unit (51), the connector (20) being designed in such a manner as to cooperate with matching portion (14) of the measuring instrument (10) provided with a photoemissive device (11) capable of receiving electric signals (V1) from an electric circuit of the measuring instrument (10) and emitting photonic signals to the photodetector (22), the connector (20) including an amplifier circuit (61) associated with the photodetector (22), this amplifier circuit (61) including two supply lines (62, 63) connected to said unit (51) between which are parallel connected, on the one hand, a resistor (64) followed by the photodetector (22) and, on the other hand, a transistor (65) of which the collector is connected to a current regulator diode (66), the transistor base being connected at the input of the photodetector (22), the collector of this transistor (65) sending the amplified signal (V3) via the cable (40) to said unit (51).

2. A device according to claim 1, characterized in that the connector (20) is provided with a photoemissive device (21) capable of emitting photonic signals to a photodetector (12) located on said portion (14), the photoemissive device (21) being connected via the cable (40) to said unit (51) and the photodetector (12) being capable of sending electric signals (V2) to said electric circuit of the measuring instrument (10).

3. A device according to claim 2, characterized in that the photoemissive device (21) provided on the connector (20) is connected via a current regulator diode (68) to said unit (51).

4. A device according to claim 3, characterized in that the connector (20) includes a body (30) of a generally flat shape exhibiting a central recess (33) in which is affixed a printed circuit (31) carrying a light emitting diode (21) acting as the photoemissive device, a phototransistor (22) acting as the photodetector, and said amplifier circuit (61), the body (30) being capable of insertion into a cavity (14) of a matching shape provided on the measuring instrument (10) in such a manner that the light emitting diode (21) be positioned facing a phototransistor (12) of the measuring instrument (10) and that its phototransistor (22) be located facing a light emitting diode (11) of the measuring instrument (10).

5. A device according to claim 4, characterized in that the connector body (30) is integral with two lateral resilient studs (23) designed for insertion into two recesses (24) provided in said cavity (14) so as to retain the connector (20) resiliently in the cavity (14).
